# EUROPÄISCHE PATENTSCHRIFT

(11) **EP 0 495 933 B1**
(45) Veröffentlichungstag und Bekanntmachung des Hinweises auf die Patenterteilung: **19.09.2001**
(21) Anmeldenummer: 91908601.7
(22) Anmeldetag: 26.04.1991
(51) Int. Cl.: H01L 31/052, F24J 2/52, F24J 2/06, F24J 2/38

(54) **PLATTFORM ZUR NUTZUNG VON SONNENENERGIE**
PLAFORM FOR THE UTILISATION OF SOLAR POWER
PLATE-FORME POUR L'UTILISATION DE L'ENERGIE SOLAIRE

(30) Priorität: 30.04.1990 DE 4013843
(43) Veröffentlichungstag der Anmeldung: 29.07.1992
(73) Patentinhaber: LAING, Johannes Nikolaus, D-71686 Remseck (DE); LAING, Ingeborg, D-71686 Remseck (DE)
(72) Erfinder: LAING, Johannes Nikolaus, D-71686 Remseck (DE); LAING, Ingeborg, D-71686 Remseck (DE)
(74) Vertreter: Rosenich, Paul, Dipl.-Ing.
(86) Internationale Anmeldenummer: EP9100808
(87) Internationale Veröffentlichungsnummer: WO9117573

(56) Entgegenhaltungen:
- DE-A- 3 633 172
- DE-A- 3 934 516
- DE-A- 3 934 517
- FR-A- 2 407 442
- FR-A- 2 460 400
- FR-A- 2 471 564
- US-A- 4 214 572
- US-A- 4 235 221
- US-A- 4 350 143
- US-A- 4 771 764
- US-A- 4 786 795
- Patent Abstracts of Japan, Band 8, Nr. 200, (E-266)[1637], 1 3. September 1984; & JP,A, 59089471 (MITSUI ZOSEN K.K.) 23. Mai 1984

## Beschreibung

### Technisches Gebiet

Die Erfindung betrifft eine Plattform zur Nutzung von Sonnenenergie, die mittels Linearkonzentratoren die Sonnenstrahlung zur Nutzung in thermischen, chemischen oder photovoltaischen Strahlungswandlern bündelt.

### Stand der Technik

Es sind Strahlungswandler bekannt, bei denen mechanische Nachführsysteme die Konzentratoren in zwei Ebenen so verschwenken, daß das Lot der Wandlerfläche stets dem Azimut und der Höhe nach exakt zur Sonne weist. Aufgrund ihrer Kompliziertheit sind derartige technische Lösungen gegenüber anderen Elektrizitätsgewinnungs-Systemen nur in Ausnahmefällen konkurrenzfähig. Außerdem bedingen alle schwenkbaren Aperturflächen zur Vermeidung einer gegenseitigen Abschattung große relative Abstände zueinander, was zu geringer Flächennnutzung führt. Wesentlich geringer ist der Aufwand, wenn nur zweidimensional konzentrierende Konzentratoren in Nord-Süd-Achse installiert einmal täglich um die Nord-Süd-Achse verschwenkt werden oder wenn parallel zu einem Durchmesser einer Plattform installierte Konzentratoren dem Azimut der Sonne durch Verdrehung der Plattform um die Hochachse nachgeführt werden. Der Nachteil dieser Anordnung liegt aber darin, daß nur geringe Umwandlungswirkungsgrade erreichbar sind, da die Strahlungsempfänger nur zweimal während des Tages kurzzeitig lotrecht bestrahlt werden.

Aufgabe der Erfindung ist es, mit einfachen Mitteln unter Vermeidung zweiachsiger Nachführsysteme eine annähernd gleichbleibende, hohe Umwandlungsrate der Sonnenstrahlung weitgehend unabhängig von der Sonnenhöhe zu gewährleisten und eine zur Verfügung stehende Grundfläche möglichst vollständig als Aperturfläche zur Bestrahlungsaufnahme zu nutzen.

US-A-4,214,752 beschreibt eine auf einer Wasserfläche aufliegende Vorrichtung, die um horizontal verlaufende Achsen schwenkbar angeordnete Parabol - Spiegelstreifen 15 enthält, die die auftreffende Sonnenstrahlung auf ein hochliegendes, dampferzeugendes Rohr 6 konzentrieren. Der Dampf wird zum Antrieb eines Generators eingesetzt und danach wieder verflüssigt. Es erfolgt sowohl eine Verschwenkung der Plattform um eine vertikale Achse als auch eine Verschenkung der konzentrierenden Spiegelstreifen um horizontale Achsen. Soll die Energiewandlung bei einer unteren Sonnenhöhe von 25° beginnen, so muß der Abstand der Parabol-Spiegelstreifen das dreifache der Höhenerstreckung der Spiegelstreifen betragen, zwei Drittel der Grundfläche tragen also nicht zur Energiewandlung bei.

Fr-A2.407.442 beschreibt eine schwimmende Plattform mit einem Dach aus Fresnel linsen, die linear konzentrieren und die konzentrierten Strahlenbüschel auf Photozellen leiten. Durch die Ausrichtung der langgestreckten Linsen in Richtung zum Sonnenazimut verläuft zwar der Fokalbereich jedes Strahlenbüschels auf Horizontalebenen unterhalb der jeweiligen Linse, er wandert jedoch vertikal, sobald die Sonnenhöhe unterhalb der Mittagshöhe absinkt (Fokalwanderung).

### Darstellung der Erfindung

Zur Vermeidung von zweiachsigen Schwenkgetrieben bei die Sonnenstrahlen konzentrierenden, sonnenenergiewandelnden Kraftwerken sieht die Erfindung eine auf einer Wasserschicht schwimmende Plattform vor, die sonnenenergiewandelnde Vorrichtungen trägt. Diese Vorrichtungen sind durch ein transparentes Dach abgedeckt, das aus zwei Schichten besteht, von denen mindestens eine rechtwinklig zu den Sonnenstrahlen verlaufende prismatische Stufen aufweist, die die Sonnenstrahlen so brechen, daß die aus ihm austretenden Strahlen spitze Winkel mit der Vertikalen einschließen. Eine mechanische Vorrichtung bewirkt, daß die Plattform der azimutalen Wanderung der Sonne folgt. Das transparente Dach kann außerdem eine Schicht aufweisen, die eine linear abbildende Fresnellinse bildet, deren prismatische Stufen rechtwinklig zu den beschriebenen prismatischen Stufen verlaufen. Enthält ein transparentes Dach außerdem eine die Strahlen konzentrierende Schicht, so kann die gleiche Scheibe auf beiden Seiten prismatische Stufen tragen, die rechtwinklig zueinander verlaufen.

In einer vorteilhaften Ausführungsform enthält das transparente Dach zwei Gruppen von Seilen, die zusammen ein Seilnetz bilden, wobei die Seile einer der Gruppen zur Sonne weisend verlaufen.

Durch die Ausbildung des strahlungswandelnden Daches durchlaufen die Strahlen zweimal pro Tag eine senkrecht zur Brennlinie verlaufende Vertikalebene. Für horizontnah einfallende Sonnenstrahlen erfolgt eine Brechung zur Vertikalebene in einem Winkel, der dem Betrage aber nicht dem Vorzeichen nach gleich dem Winkel ist, den zenitnahe Strahlen nach der Brechung mit der Vertikalebene einschließen.

Die zur Sonne weisenden Flanken der Stufen von übereinander liegenden Dachelementen sollen mit der Vertikalen einen solchen Winkel einschließen, daß auf sie auftreffende Sonnenstrahlen innerhalb des gleichen Winkelintervalles aus der Stufenlinse austreten wie die zwischen den Flanken hindurchgehenden Sonnenstrahlen.

Der Strahlungswandler kann entlang seiner Längsseiten von sammelnden Spiegeln begrenzt sein, deren zum optischen System weisende obere Ränder einen größeren Abstand haben, als die Breite des Strahlungswandlers. Dabei soll die Krümmung der sammelnden Spiegel so gewählt sein, daß sowohl die zenitnahen als auch die horizontnahen Strahlen auf den Strahlungswandler reflektiert werden.

An die Stelle der Fresnellinsen können auch parallel zum zur Sonne weisenden Durchmesser verlaufende Spiegeltröge treten, die durch schwimmende Rohre getragen werden. Durch ein in dem Fokalbereich angeordnetes zylindrisches Umlenkelement läßt sich die gebündelte Strahlung auf einen Strahlungswandler konzentrieren.

Eine weitere Variante sieht eine auf die Flüssigkeit aufgelegte, diese vollständig abdeckende Folie vor, auf der die sonnenenergiewandelnden Vorrichtungen mit den horizontale Träger haltenden Streben zusammen mit Kühlwasserrohren gelagert sind.

Zur Sonnenfindung ist es vorteilhaft, beidseitig der Brennlinie benachbarte, mit einem wärmeausdehnenden Medium gefüllte, geschwärzte, an ihren Enden geschlossene Rohre anzuordnen, die die Rückführung von ausgewanderten Strahlen bewirken.

### Kurze Beschreibung der Erfindung

Die Erfindung soll anhand der Figuren beispielhaft näher erläutert werden:
Fig.1 zeigt die Konzentration der Strahlen und die zum Lot gerichtete Brechung.
Fig.2 zeigt einen Querschnitt durch eine transparente Wandung mit dem Strahlengang für unterschiedliche Sonnenhöhen.
Fig.3 zeigt eine Flachlinse, die sowohl konzentriert als auch nach unten ablenkt.
Fig.4 zeigt den vorteilhaften Abstand des Strahlungsempfängers von der konzentrierenden Flachlinse zur Kompensation der Vertikalverschiebung der Brennlinie.
Fig.5 zeigt eine Kompensationsmöglichkeit mittels einer Linse.
Fig.6 zeigt eine weitere Linsenanordnung.
Fig.7 zeigt eine Anordnung mit zwei stabförmigen Prismen.
Fig.8 zeigt die Kompensation durch zwei Spiegelstreifen.
Fig.9 zeigt den Gesamtaufbau mit schwimmender Plattform.
Fig.10 zeigt einen Schnitt durch die Randzone eines Kraftwerkes gemäß Fig.9.
Fig.11 zeigt eine Variante mit abgedeckter Wasserfläche.
Fig.12 zeigt den Strahlungsverlauf im Fokalbereich der Anordnung gemäß Fig.11.
Fig.13 zeigt einen Querschnitt durch eine Plattform mit Parabolspiegeln.

### Wege zur Ausführung der Erfindung

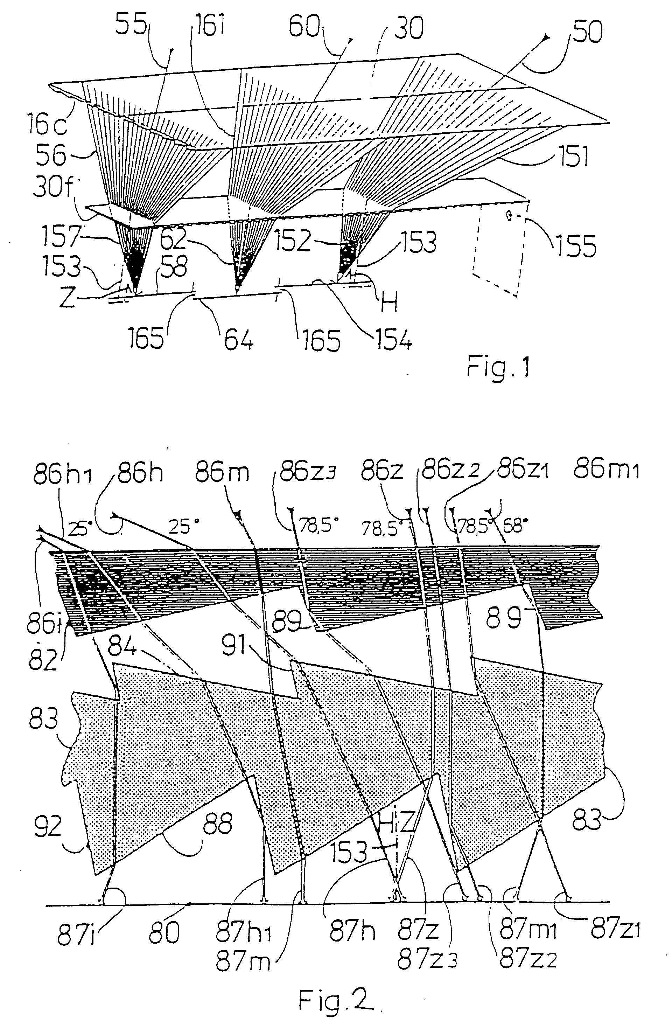

In der Fig.1 erzeugt eine Fresnellinse 30 mit parallel zur Vertikalebene, in der die Sonnenstrahlen 50, 55, 60 liegen, verlaufenden Stufen 16c Strahlenbüschel 56, 151, 161, die durch die transparente Schicht 30f, die rechtwinklig zu den Stufen 16c verlaufende Stufen aufweist, nach unten hin gebrochen werden. Während der Morgen- und Abendstunden erzeugt die horizontnahe Einstrahlung 50 ein Strahlenbüschel 151. Dieses wird von der transparente Schicht 30f zu einem Strahlenbüschel 152 zum Lot 153 hin gebrochen und erzeugt die Brennlinie 154. Im Mittagspunkt bildet die nunmehr fast senkrechte Einstrahlung 55 ein Strahlenbüschel 56, welches beim Durchtritt durch die transparente Wandung 30f zum Strahlenbüschel 157 nach unten gerichtet gebrochen wird. Dieses schließt mit dem Lot 153 den Winkel Z ein. Das Strahlenbüschel 152 schließt mit dem Lot den dem Betrage nach gleich großen Winkel H, jedoch mit umgekehrten Vorzeichen ein. Am Vormittag und am Nachmittag durchläuft die Einstrahlung die Richtung des Pfeiles 60. Diese Strahlen werden zu einem Strahlenbüschel 161 gebrochen. Dieses Strahlenbüschel 161 erfährt beim Durchtritt durch die transparente Schicht 30f eine Brechung, die zu einem zum Lot 153 parallelen Strahlenbüschel 62 führt. Die diesem Strahlenbüschel 62 zugeordnete Brennlinie 64 liegt um einen Betrag 165 unter der Brennlinie 154 der horizontnahen Einstrahlung und auch unter der Brennlinie 58 der Mittagseinstrahlung.

Fig.2 zeigt ein Beispiel für ein transparentes Dach, das aus den Stufenlinsen 82 und 83 besteht und die Sonnenstrahlen unabhängig von der Sonnenhöhe innerhalb eines engen Winkelintervalles H-Z austreten läßt, wobei die austretenden Strahlen 87h und 87z zwischen sich das Lot 153 einschließen. Alle nicht von der Sonnenstrahlung durchdrungenen Flanken 89, 91 und 92 weisen zur Sonne. Der Vormittags/Nachmittagsstrahl 86m tritt nach viermaliger Brechung parallel zum Lot 153 als Austrittsstrahl 87m aus. Ein horizontnaher Strahl 86h wird nach viermaliger Brechung zum Austrittsstrahl 87h, der mit dem Lot 153 den Winkel H einschließt. Der zenitnahe Strahl 86z wird zum Austrittsstrahl 87z, der mit dem Lot 153 einen Winkel Z einschließt, der dem Betrage nach dem Winkel H gleicht. Trifft der Vormittagsstrahl oder Nachmittagsstrahl 86m1 auf die Flanke 89, so erfährt der Strahlengang des Strahles 86m1 eine Reflexion an der Flanke 89, die zu einer solchen Winkeländerung des anschließenden Strahlenganges führt, daß der Strahl 87m1 nach der vierten Brechung mit einem Winkel zum Lot 153 austritt, der innerhalb des Grenzwinkel - Intervalls H-Z liegt. Das gleiche gilt für den zenitnahen Strahl 86z1, der eine Reflexion an der Flanke 91 erfährt und als Strahl 87z1 annähernd parallel zum Strahl 87h aus der Stufenlinse 83 austritt. Erfolgt nach dreimaliger Brechung eine Totalreflexion des Strahles 86z2 an der Flanke 92, tritt der Strahl als Austrittsstrahl 87z2 aus, wobei er ebenfalls innerhalb des Grenzwinkel - Intervalls H-Z verläuft. Auf Grund des Winkels der Flanke 89 zur Vertikalen erfährt der Strahl 86z3 ebenfalls eine Totalreflexion, die zu einem Austrittsstrahl 87z3 führt, der auch innerhalb des Grenzwinkel - Intervalls H-Z verläuft. Trifft der horizontnahe Strahl 86h 1 gegen eine der Flanken 89, 91 oder 92, so wird der überwiegende Teil reflektiert und tritt z.B. als Strahl 87h1 innerhalb des Grenzwinkel - Intervalls H-Z verlaufend aus. Der Verlauf des Strahles 86i, der mit einem Winkel auf die Flachlinse 82 auftrifft, der zwischen dem Winkel des horizontnahen Strahles 86h und dem des Mittagsstrahles 86m liegt, führt zu einem Austrittsstrahl 87i, der ebenfalls innerhalb des Grenzwinkel - Intervalls H-Z verläuft.

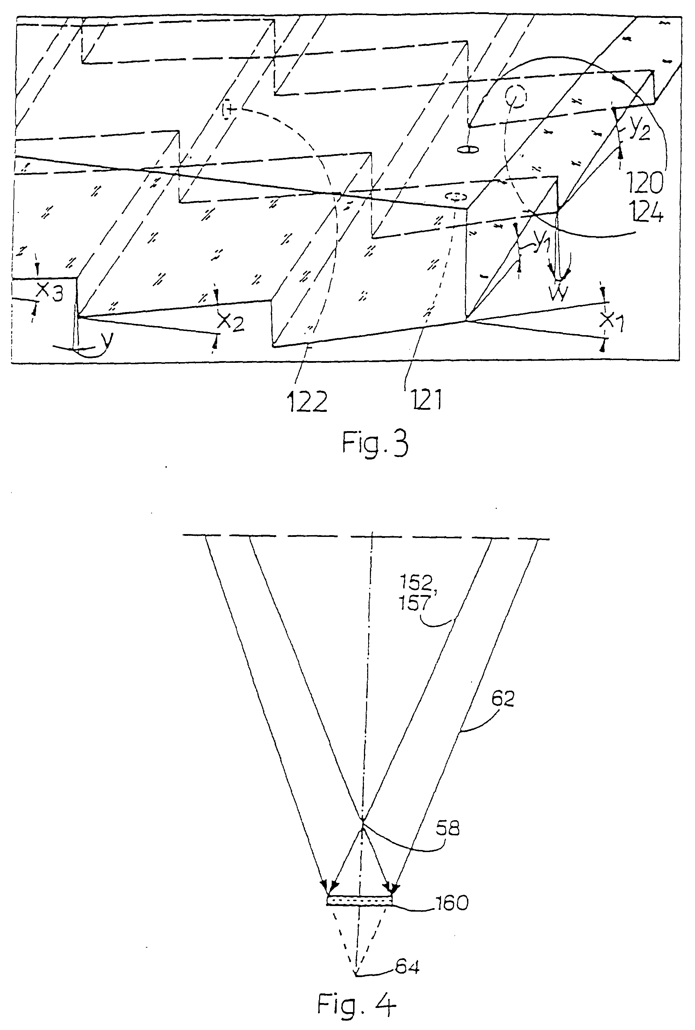

In Fig.3 ist ein transparentes Dachelement dargestellt, das die Funktionen einer Fresnellinse und einer nach unten gerichtet brechenden Schicht übernimmt. Die plane Oberseite des transparenten Dachelementes 120 bildet die Eintrittsfläche. In den senkrecht zur Sonneneinstrahlung verlaufenden Flanken bilden die Rechteckbereiche 121 mit der Horizontalen die Winkel x1 x2, x3,...., die in der Vertikalebene, in der die Brennlinie liegt, zu Null werden. Die zum Energiewandler weisenden Flächen der Rechteckbereiche 121 sind dazu gleichzeitig in zur Sonne weisenden Ebenen um den konstant bleibenden Winkel y1, y2 geneigt. Es entstehen dadurch Strahlenbüschel, die gleichzeitig zum Lot hin gebrochen sind. Wie bei konventionellen Fresnellinsen bilden die Flanken 122 mit der planen Oberseite 120 den ebenfalls zur Brennlinienebene hin abnehmenden Winkel v mit der Vertikalen. Die senkrecht dazu verlaufenden Flanken 124 schließen mit der Vertikalen den Winkel w ein, der vom Strahlenverlauf innerhalb der transparenten Schicht nach Eintritt der Vormittags- bzw. Nachmittagsstrahlen durch die Oberfläche 120 gefordert wird. Die durch die beschriebene Schicht gebildeten Strahlenbüschel werden durch eine weitere Stufenlinse zum Lot 153 hin ein zweites Mal gebrochen.

Fig.4 zeigt eine Anordnung eines als Photozelle 160 ausgebildeten Strahlungswandlers, auf den von einer konzentrierenden und gleichzeitig nach unten brechenden Schicht erzeugte Strahlenbüschel auftreffen. Die Brennlinie 58 in Fig.1, die dem bis zum Grenzwinkel geneigten Strahlenbüschel 152 bzw.157 zugeordnet ist, verläuft in annähernd gleichem vertikalem Abstand oberhalb der Photozelle 160, wie die Brennlinie 64 des Strahlenbüschels 62 unterhalb derselben verlaufen würde. Hierdurch ist sichergestellt, daß die Photozelle 160 in annähernd voller Breite der konzentrierten Strahlung ausgesetzt ist.

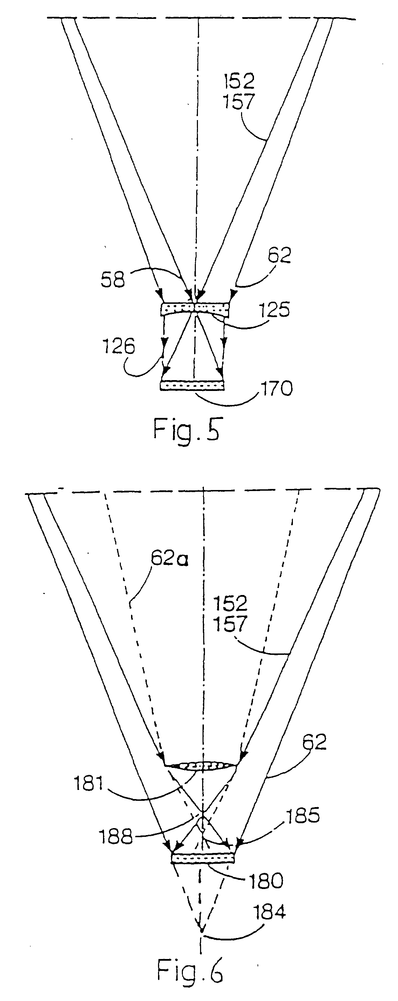

Fig.5 zeigt eine Anordnung, bei der eine strangförmige Zerstreuungslinse 125 das senkrecht einfallende Strahlenbüschel 62 zu Parallelstrahlen 126 aufweitet, während die Brennlinie 58 der mit Grenzwinkelneigung einfallenden Strahlenbüschel 152 und 157 mit der Achse der strangförmigen Zerstreuungslinse 125 zusammenfällt, so daß auch diese Strahlung auf der gesamten Breite der Photozelle 170 auftrifft.

Fig.6 zeigt eine Anordnung, bei der die Photozelle 180 oberhalb des geometrischen Ortes 184 der Brennlinie des senkrecht auftreffenden Strahlenbüschels 62 angeordnet ist. Oberhalb des geometrischen Ortes der Brennlinie 185 der mit Grenzwinkelneigung einfallenden Strahlenbüschel 152 und 157 ist eine Sammellinse 181 angeordnet, deren Brennlinie 185 des Strahlenbüschelanteils 62a in geringem Abstand oberhalb der Photozelle 180 liegt. Die mit Grenzwinkelneigung einfallenden Strahlenbüschel 152 und 157 erzeugen eine Brennlinie 188, die annähernd in der Mitte zwischen der Photozelle 180 und der Sammellinse 181 liegt. Die Breite der zylindrischen Sammellinse 181 wird dabei von den Strahlenbüscheln 152 und 157 bestimmt.

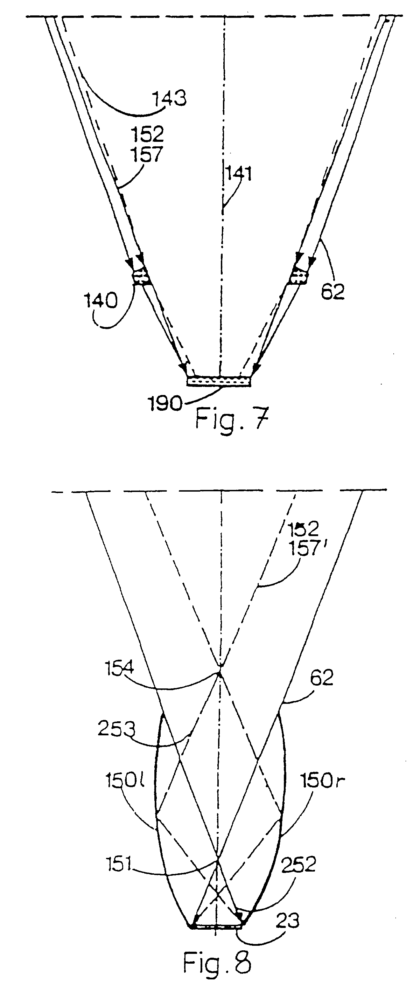

Fig.7 zeigt eine Anordnung zur Kompensation der unterschiedlichen Höhe der Fokalline während des Tages, bei der die Photozelle 190 in ihrer gesamten Breite von den mit Grenzwinkelneigung einfallenden Strahlenbüscheln 152 und 157 getroffen wird. Nur der innere Bereich 143 des senkrecht einfallenden Strahlenbüschels 62 trifft direkt auf die Photozelle 190. Die äußeren Bereiche des senkrecht auftreffenden Strahlenbüschels 62, die die Photozelle ohne Hilfsmittel nicht treffen würden, werden durch die beiden stabförmigen Prismen 140 in Richtung zum Lot 141 hin gebrochen.

Fig.8 zeigt eine Anordnung, bei der die Photozelle 23 von zwei gekrümmten Spiegelstreifen 150r und 150l eingeschlossen ist. Der Abstand der Photozelle 23 von der transparenten, konzentrierenden Schicht wird so gewählt, daß das senkrecht einfallende Strahlenbüschel 62 eine Brennlinie 151 erzeugt, die in solchem Abstand oberhalb der Photozelle 23 verläuft, daß die Breite des divergierenden Bereiches 252 der Breite der Photozelle 23 entspricht und daß der divergierende Bereich 253 unterhalb der zugeordneten Brennlinie 154 die mit Grenzwinkelneigung einfallenden Strahlenbüschel 152 und 157 auf die Photozelle 23 reflektiert.

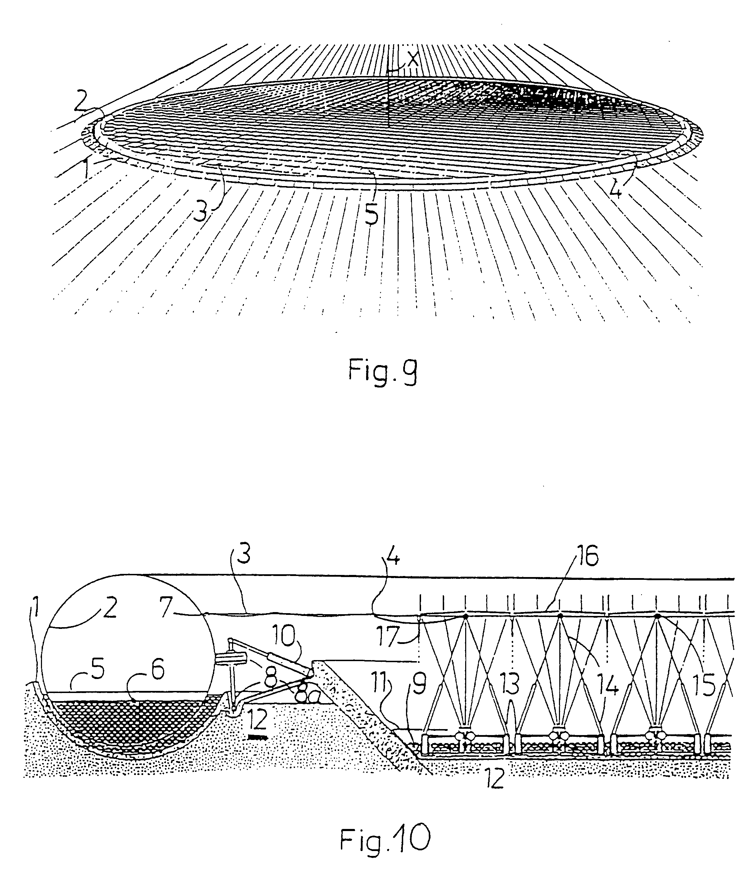

Eine vorteilhafte Ausführung einer kreisförmigen Plattform zur Solarstromgewinnung mit einem nach unten gerichtet brechenden und konzentrierenden transparenten Dach ist in den Figuren 9 und 10 dargestellt. In einer mit Wasser gefüllten Rinne 1, schwimmt ein Stahlrohr 2. Innerhalb der von der Rinne 1 eingeschlossenen Kreisfläche ist eine Folie 11 ausgelegt, die auf plan gemachtem Erdreich 12 aufliegt. Am Rand der Kreisfläche ist die Folie 11 hochgezogen, so daß ein Becken für die Wasserschicht 9 gebildet wird, auf der die parallel zum Durchmesser der Plattform verlaufenden Einheiten 13 schwimmen. Das transparente Dach 16 ist leicht geneigt, so daß auftreffendes Wasser über Abflüsse 17 zwischen den Dachelementen 16 abfließen kann.

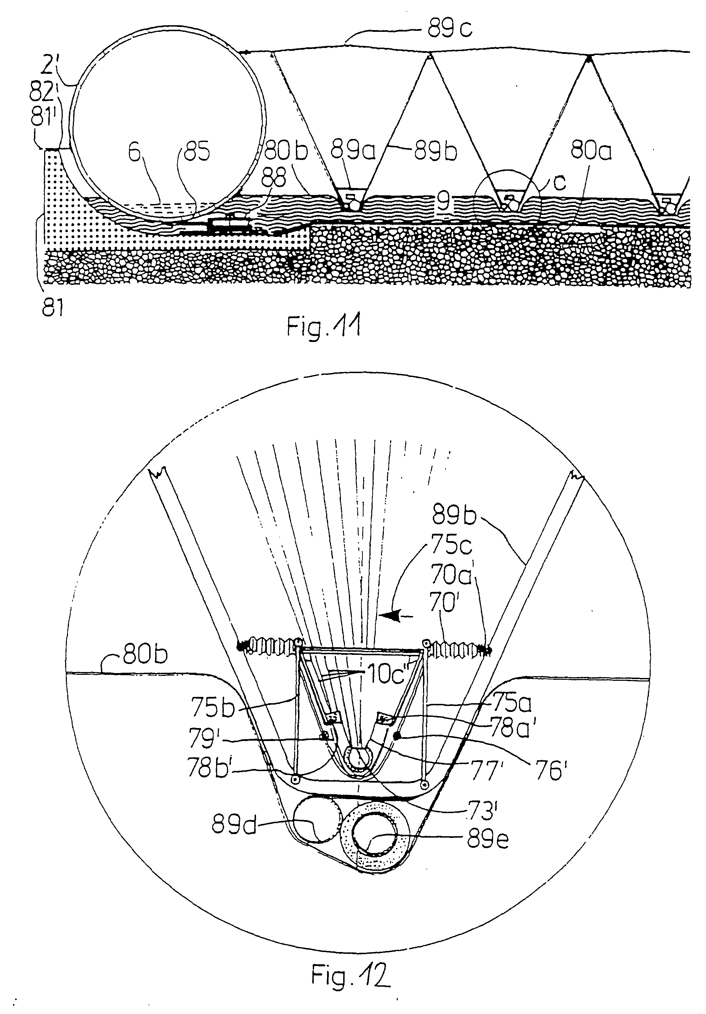

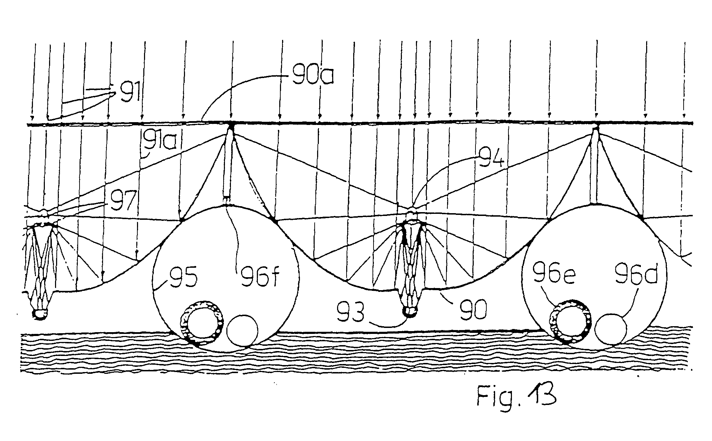

Bei der in Fig.11 dargestellten Variante der Plattform ist die Kreisfläche von einer Mauer 81 eingefaßt und durch eine Folie 80a zum Erdreich hin abgedichtet. Das so gebildete Becken ist mit Wasser 9 gefüllt. Längs der unteren Mantellinie des Rohres 2' ist ein Ring 85 befestigt, der in Rollen 88, die radial verschieblich angeordnet sind, eingreift. Diese Rollen zentrieren den die Plattform bildenden schwimmenden Bereich. Am Rohr 2' ist eine Folie 80b befestigt, die die gesamte Wasserschicht abdeckt. In vorgegebenen Abständen sind parallel zueinander verlaufende sonnenenergiewandelnde Vorrichtungen 89a angeordnet, die über Streben 89b die transparenten Dachelemente 89c tragen. Der mit C eingekreiste Bereich ist vergrößert in Fig. 12 gezeigt.

Die in Fig.12 gezeigten V-förmig gebogenen Streben 89b liegen auf den Kühlwasserrohren 89e und 89d auf und verursachen zusammen mit diesen in der Folie 80b rinnenförmige Einbuchtungen, die sich über den gesamten zur Sonne gerichteten Durchmesser bzw. über die Länge von parallel dazu verlaufenden Sehnen erstrekken. Vom parallel zum Strahlungswandler verlaufenden Rohr 78b' führt eine Leitung 79' zum Faltenbalg 70' der unter Zwischenschaltung einer Schraubenfeder 70a' mit der Strebe 89b verbunden ist. Wenn von der Photozelle 73' ausgewanderte Strahlen 10c" auf das Rohr 78b' fallen, wird durch Wärmeausdehnung ein Teil der eingeschlossenen Flüssigkeit in den Faltenbalg 70' gefördert, wodurch die über Gelenkhebel 75a und 75b verschieblich angeordnete Photozelle 73' in Richtung des Pfeiles 75c verschoben wird, so daß die ausgewanderten Strahlen 10c" wieder innerhalb der Spiegelstreifen 77' auftreffen.

Die in Fig.13 dargestellte weitere Anordnung zur Nutzung der Sonnenenergie mittels einer dem Sonnenazimut folgenden schwimmenden Vorrichtung besitzt statt brechender Konzentratorlinsen parabolische Spiegeltröge 90, auf die durch ein transparentes, die Sonnenstrahlen 91 nach unten gerichtet brechendes Dach 90a in Richtung zur Vertikalen hin gebrochene Strahlen 91a fallen. In der Nähe des Fokalbereiches 97 jedes Spiegeltroges 90 und parallel zu diesem ist eine stabförmige Linse 94, angeordnet. An der Unterseite der stabförmigen Linse 94 tritt die konzentrierte Strahlung aus, die annähernd senkrecht auf einen unterhalb der Spiegeltröge 90 angeordneten Strahlungswandler 93 gerichtet ist.

## Patentansprüche

1. Um die Hochachse drehbare, schwimmende Plattform, deren Durchmesser dem Azimut der Sonne nachgeführt wird, zur Konzentration und Energieumwandlung der Sonnenstrahlen, bestehend aus einer Vielzahl von parallel zum Plattformdurchmesser verlaufenden, durch ein transparentes Dach abgedeckten Bereichen, die über ihre Länge sich erstreckende Strahlungswandler aufweisen, **dadurch gekennzeichnet, daß** das transparente Dach (16, 89c, 90a) mindestens zwei übereinanderliegende Schichten (30, 30f; 82, 83) aufweist, die prismenbildende, senkrecht zum Plattformdurchmesser verlaufende Stufen (85, 89; 84, 91; 88, 92) tragen, die die auftreffenden Sonnenstrahlen (50, 55, 60) so brechen, daß die Strahlen innerhalb eines spitzwinkligen, nach unten gerichteten Winkelintervalles (zwischen 86h und 86z) durch eine optische Einrichtung (16c, 121, 30f, 90) konzentriert werden und auf den parallel zum Plattformdurchmesser verlaufenden Strahlungswandler (23, 33, 73') auftreffen.

2. Plattform nach Anspruch 1, **dadurch gekennzeichnet, daß** die Winkel zwischen den optischen Grenzflächen ( 84, 85, 88) der Prismen und der Horizontalen (80) so gewählt sind, daß alle eintretenden Sonnenstrahlen (86h bis 86z) in Richtung zur Sonne gebrochen werden, wobei die Vertikale (153) innerhalb des Austrittswinkelintervalles (87h bis 87z) verläuft.

3. Plattform nach Anspruch 2, **dadurch gekennzeichnet, daß** die Vertikale (153) die Winkelhalbierende des das Austrittswinkelintervall (zwischen 87h und 87z) inschließenden Winkels bildet.

4. Plattform nach Anspruch 1, **dadurch gekennzeichnet, daß** die optische Einrichtung (16c, 121, 30f) parallel zueinander und zum Plattformdurchmesser verlaufende, konzentrierende Prismen aufweist.

5. Plattform nach Anspruch 1, **dadurch gekennzeichnet, daß** die konzentrierende optische Einrichtung durch spiegelnde, parallel zum Plattformdurchmesser verlaufende Tröge (90) gebildet wird.

6. Plattform nach Anspruch 1, **dadurch gekennzeichnet, daß** eine der übereinanderliegenden Schichten (16, 30u,40b,89c) auf ihrer nach unten weisenden Seite in viele Bereiche (121) aufgegliedert ist, wobei diese Bereiche (121) sowohl zur Sonne gerichtete Flanken (124) als auch senkrecht dazu verlaufende Flanken (122) aufweisen, und daß die nach unten weisenden Flächen dieser Bereiche (121) so geneigt sind, daß die Sonnenstrahlen als Strahlenbündel austreten, die auf den Strahlungswandler (23, 33, 73') gerichtet sind, und daß gleichzeitig schräg auftreffende Sonnenstrahlen (50) zur Vertikalen (153) hin gebrochen werden.

7. Plattform nach Anspruch 1, **dadurch gekennzeichnet, daß** das transparente Dach (40b,89c) im senkrecht zum Plattformdurchmesser verlaufenden Querschnitt nach unten abgebogen ist.

8. Plattform nach Anspruch 1, **dadurch gekennzeichnet, daß** ein Ausgleich zwischen unterschiedlichen Abbildungslängen zugeordneten Brennlinien (58, 154, 164) erfolgt.

9. Plattform nach Anspruch 1, **dadurch gekennzeichnet, daß** eine der Schichten (82, 83) auf der nach unten weisenden Oberfläche eine hydrophile Beschichtung trägt.

10. Plattform nach Anspruch 1, **dadurch gekennzeichnet, daß** längs der beiden Seiten eines Strahlungswandlers (73, 73') und außerhalb des Strahlenbüschels (10b) Sensoren (78a', 78b) verlaufen, die bei Auftreffen ausgewanderter Sonnenstrahlen (10c', 10c") eine Verschiebung des Strahlungswandlers (73, 73') in Richtung der ausgewanderten Sonnenstrahlen bewirken.

## Claims

1. A floating platform, rotatable around the vertical axis, the platform's diameter being guided to follow the azimuth of the sun, to concentrate and convert the energy of the sun's rays, consisting of a plurality of areas, positioned parallel to the diameter of the platform, covered by a transparent roof, and comprising energy converters extending over the whole length of said areas, **characterized in that** the transparent roof (16, 89c, 90a) has at least two layers (30, 30f; 82, 83) on top of each other, comprising prism shaped steps (85, 89; 84, 91; 88, 92) which run perpendicular to said platform diameter, which steps refract the incident sun rays (50, 55, 60) into a downwards directed acute angular interval (between 86h and 86z) and that the rays will be concentrated by optical means (16c, 121, 30f, 90) so that they impinge onto the energy converters (23, 38, 73') positioned parallel to the platform diameter.

2. Platform according to claim 1, **characterized in that** the angles between the optical boundary layers (84, 85, 88) of the prisms and of the horizontal (80) are chosen in such a way that all incoming sun rays (86h to 86z) are refracted in the direction of the sun, whereby the vertical (153) runs within the emerging angular interval (87h to 87z).

3. Platform according to claim 2, **characterized in that** the vertical (153) forms the bisector of the angle which includes the emerging angular interval (between 87h and 87z).

4. Platform according to claim 1, **characterized in that** the optical means (16c, 121, 30f) comprise concentrating prisms running parallel to each other and to the platform diameter.

5. Platform according to claim 1, **characterized in that** the concentrating optical means are formed by reflecting troughs (90) running parallel to the platform diameter.

6. Platform according to claim 1, **characterized in that** one of the layers placed on top of each other (16, 30u, 40b, 89c) on its lower side is divided into a plurality of areas (121) whereby these areas (121) have flanks (124) facing the sun as well as flanks (122) running perpendicular to these flanks (124) and that the downward facing planes of these areas (121) are tilted in such a way that the sun's rays exit as wedges of rays which are directed towards the energy converter (23, 33, 73') and that at the same time solar rays (50) impinging under an oblique angle are being refracted towards the vertical (153).

7. Platform according to claim 1, **characterized in that** the transparent roof (40b, 89c) in its cross-section perpendicular to the platform diameter is bent downwards.

8. Platform according to claim 1, **characterized in that** a compensation takes place between the focal lines (58, 154, 164) attributed to different projection lengths.

9. Platform according to claim 1, **characterized in that** one of the layers (82, 83) has a hydrophilic coating on its downwards facing surface.

10. Platform according to claim 1, **characterized in that** sensors (78a',78b) are arranged along both sides of the energy converters (73,73') outside of the wedges of rays (10b), said sensors causing a shifting of said energy converters (73, 73') in the direction of the stray rays, when said sensors are exposed to stray rays (10c', 10c").

## Revendications

1. Plate-forme flottante susceptible de tourner autour de l'axe vertical, dont le diamètre suit l'azimut du soleil, pour concentrer et assurer la conversion d'énergie des rayons solaires, constituée d'une pluralité de zones s'étendant parallèlement au diamètre de la plate-forme, couvertes par un toit transparent, présentant des convertisseurs de rayonnement s'étendant sur leur longueur, **caractérisée en ce que** le toit transparent (16,89c,90a) présente au moins deux couches (30,30f;82,83) superposées, portant des étagements (85,89; 84,91; 88,92) formant des prismes, s'étendant perpendiculairement par rapport au diamètre de la plate-forme, étagements qui assurent la diffraction des rayons solaires (50,55,60) incidents, en ce que les rayons sont concentrés dans les limites d'une plage angulaire (entre 86h et 86z) orientée vers le bas, les angles étant aigus, au moyen d'un dispositif optique (16c, 121,30f,90) et frappent le convertisseur de rayonnement (23,33,73') s'étendant parallèlement au diamètre de la plate-forme.

2. Plate-forme selon la revendication 1, **caractérisée en ce que** les angles, entre les surfaces limites optiques (84,85,88) des prismes et l'horizontale (80), sont choisis tels que tous les rayons solaires incidents (86h à 86z) subissent une diffraction par rapport à la direction du soleil, la verticale (153) s'étendant dans les limites de la plage angulaire de sortie (87h à 87z).

3. Plate-forme selon la revendication 2, **caractérisée en ce que** la verticale (153) forme la bissectrice angulaire de l'angle incluant la plage angulaire de sortie (entre 87h et 87z).

4. Plate-forme selon la revendication 1, **caractérisée en ce que** le dispositif optique (16c,121,30f) présente des prismes concentrateurs, parallèles entre eux et s'étendant parallèlement entre eux et par rapport au diamètre de la plate-forme.

5. Plate-forme selon la revendication 1, **caractérisée en ce que** le dispositif optique concentrateur est formé par des cuvettes (90) réfléchissantes, s'étendant parallèlement au diamètre de la plate-forme.

6. Plate-forme selon la revendication 1, **caractérisée en ce que** l'une des couches (16,30u,40b,89c) est décomposée, sur sa face tournée vers le bas, en un grand nombre de zones (121), ces zones (121) présentant tant des flancs (124) tournés vers le soleil, que des flancs (122) s'étendant perpendiculairement à celui-ci, et en ce que les surfaces, tournées vers le bas, de ces zones (121) sont inclinées de manière que les rayons solaires sortent sous forme de faisceaux de rayon, orientés sur le convertisseur de rayonnement (23,33,73'), et en ce que, simultanément, des rayons solaires (50) incidents, arrivant obliquement, sont soumis à diffraction par rapport à la verticale (153).

7. Plate-forme selon la revendication 1, **caractérisée en ce que** le toit transparent (40b,89c) est coudé vers le bas, dans la section transversale s'étendant perpendiculairement par rapport au diamètre de la plate-forme.

8. Plate-forme selon la revendication 1, **caractérisée en ce qu'**une compensation est effectuée entre des axes focaux (58,154,164) associés à des longueurs de reproduction différentes.

9. Plate-forme selon la revendication 1, **caractérisée en ce que** l'une des couches (82,83) porte un revêtement de nature hydrophile, sur la surface tournée vers le bas.

10. Plate-forme selon la revendication 1, **caractérisée en ce que** le long des deux côtés d'un convertisseur de rayonnement (73,73') et à l'extérieur du faisceau de rayonnement (10b) s'étendent des capteurs (78a',78b) qui, en cas de dérive de l'incidence de rayons solaires (10c',10c"), provoquent un déplacement du convertisseur de rayonnement (73,73'), dans la direction de la dérive des rayons solaires.
